# FASCICULE DE BREVET EUROPEEN

(11) **EP 1 672 802 B1**
(45) Date de publication et mention de la délivrance du brevet: **30.04.2008**
(21) Numéro de dépôt: 05112069.9
(22) Date de dépôt: 13.12.2005
(51) Int. Cl.: H03M 1/12, H04B 10/158, H04L 27/233

(54) **Dispositif d'échantillonnage hautes fréquences**
Hochgeschwindigkeitsabtastgerät
High frequency sampling device

(30) Priorité: 15.12.2004 FR 0413342
(43) Date de publication de la demande: 21.06.2006
(73) Titulaire: THALES, 92200 Neuilly sur Seine (FR)
(72) Inventeur: Formont, Stéphane, 91570 Bievres (FR); Breuil, Nicolas, 91400 Orsay (FR); Chazelas, Jean, 75015 Paris (FR)
(74) Mandataire: Lucas, Laurent Jacques

(56) Documents cités:
- EP-A- 1 324 056
- US-B1- 6 384 590
- BROEKAERT T P E ET AL: "INP-HBT OPTOELECTRONIC INTEGRATED CIRCUITS FOR PHOTONIC ANALOG-TO-DIGITAL CONVERSION" IEEE JOURNAL OF SOLID-STATE CIRCUITS, IEEE INC. NEW YORK, US, vol. 36, no. 9, septembre 2001 (2001-09), pages 1335-1342, XP001168166 ISSN: 0018-9200
- UMBACH A: "High-speed integrated photodetectors for 40 Gbit/s applications" PROCEEDINGS OF THE SPIE - THE INTERNATIONAL SOCIETY FOR OPTICAL ENGINEERING SPIE-INT. SOC. OPT. ENG USA, vol. 5246, no. 1, 2003, pages 434-442, XP002333520 ISSN: 0277-786X

## Description

La présente invention concerne un dispositif d'échantillonnage hautes fréquences. Elle s'applique notamment pour la conversion analogique-numérique de signaux dont les fréquences sont très élevées.

L'échantillonnage de signaux analogiques dont les fréquences sont très importantes est très difficile avec les techniques d'échantillonnage conventionnelles lorsque l'on cherche un nombre de bits et donc une résolution élevée. Il n'est en effet pas possible d'obtenir à la fois la bande passante nécessaire pour échantillonner ces signaux et la résolution la plus grande (nombre de bits). Afin d'obtenir à la fois la résolution et la cadence d'échantillonnage, une technique couramment utilisée consiste à entrelacer plusieurs convertisseurs analogiques numériques dont la cadence d'échantillonnage est plus faible et la résolution plus élevée, afin d'obtenir globalement la bonne cadence d'échantillonnage et le bon nombre de bits. Ainsi, si n convertisseurs 1 giga-échantillons par seconde de 10 bits sont entrelacés, la cadence globale d'échantillonnage est de n giga-échantillons par seconde avec une résolution ultime de 10 bits.

Afin de pouvoir échantillonner des signaux à très haute fréquence, plusieurs GHz par exemple, il est nécessaire de disposer d'un dispositif dont le temps d'ouverture pour la prise d'échantillon est compatible avec la fréquence maximale du signal à échantillonner, c'est à dire de plusieurs picosecondes.

Un document TPE. Broekaert et al "INP-HBT Optoelectronic integrated circuits for photonic analog-to-digital conversion" IEEE Journal of Solid-State circuits, IEEE Inc. New York, US, vol.36, n°9, septembre 2001, pages 1335-1342, divulgue un dispositif d'échantillonnage à base de convertisseur electro-optique.

Un but de l'invention est notamment de permettre la création d'impulsions ultra courtes. A cet effet, l'invention a pour objet un dispositif d'échantillonnage tel que défini par la revendication 1.
Le convertisseur optique-électrique fournit en sortie un signal proportionnel au signal de modulation de la porteuse optique lorsque la tension est par exemple non nulle.

Avantageusement, le convertisseur optique-électrique peut être une photodiode dont la polarisation est commandée par les impulsions de tension. Les impulsions de tension sont par exemple générées à partir d'une tension d'alimentation commutée, la tension étant commutée par un commutateur photoconducteur, le commutateur photoconducteur étant activé par des impulsions optiques.

Avantageusement, le dispositif comporte par exemple une deuxième photodiode illuminée par la porteuse optique, la deuxième photodiode n'étant pas polarisée et son signal de sortie étant soustrait au signal de sortie de la première photodiode pour former le signal de sortie échantillonné.
Ainsi, la sortie du deuxième photodétecteur est par exemple reliée à un déphaseur de 180°, la sortie du premier photodétecteur et la sortie du déphaseur étant reliées aux entrées d'un sommateur dont la sortie fournit le signal de sortie échantillonné.

Dans un autre mode de réalisation avantageux, le dispositif comporte par exemple une deuxième photodiode qui n'est pas illuminée par la porteuse optique, la cathode de la deuxième photodiode étant reliée à l'anode de la première photodiode, les deux photodiodes étant commandées en tension simultanément, le signal de sortie échantillonné étant situé au point milieu des deux photodiodes.

Avantageusement, la tension de polarisation est par exemple appliquée sur la photodiode via une résistance, la tension de polarisation étant annulée par un commutateur à commande impulsionnelle, un filtre passe-bas filtrant le signal en sortie de la photodiode, la sortie du filtre fournissant le signal de sortie échantillonné. Le commutateur à commande impulsionnelle est par exemple un commutateur à commande optique portant la résistance à un potentiel de référence lorsqu'il reçoit une impulsion optique. L'anode de la photodiode est par exemple reliée à la résistance et au commutateur à commande optique, la résistance étant par ailleurs reliée à une tension d'alimentation, le commutateur étant activé par des impulsions optiques.

Dans un autre mode de réalisation avantageux, le dispositif comporte par exemple une deuxième photodiode illuminée par la porteuse optique, la cathode de la deuxième photodiode étant reliée à l'anode de la première photodiode, les deux photodiodes étant commandées en tension simultanément, la première photodiode ayant sa tension de polarisation commandée de façon impulsionnelle, un filtre passe-bas étant connecté au point milieu des deux photodiodes, la sortie du filtre passe-bas délivrant le signal de sortie échantillonné. La première photodiode est par exemple reliée à une tension d'alimentation +V par une résistance, la deuxième photodiode est reliée à une tension d'alimentation -V par une résistance, la cathode de la première photodiode étant annulée par un commutateur à commande impulsionnelle.

Avantageusement, la porteuse optique est par exemple échantillonnée dans le domaine optique. A cet effet, le convertisseur électro-optique comporte par exemple une source laser impulsionnelle couplée à un modulateur électro-optique.

D'autres caractéristiques et avantages de l'invention apparaîtront à l'aide de la description qui suit faite en regard de dessins annexés qui représentent :
- la figure 1, un exemple de réalisation d'un dispositif selon l'invention à base d'un convertisseur électrique-optique et d'un convertisseur optique-électrique commandé en tension impulsionnelle ;
- la figure 2, un exemple de réalisation selon l'invention comportant une photodiode commandée par des impulsions optiques et une tension d'alimentation via un commutateur à commande optique ;
- la figure 3, un autre exemple de réalisation selon l'invention comportant deux photodiodes illuminées par une même porteuse optique véhiculant un signal à échantillonner ;
- la figure 4, un exemple de réalisation selon l'invention où la porteuse optique est elle-même échantillonnée ;
- la figure 5, un exemple de réalisation selon l'invention comportant deux photodiodes reliées chacune à une tension de polarisation ;
- la figure 6, un exemple de réalisation selon l'invention où la tension de polarisation de la photodiode est commandée par un commutateur de mise à zéro ;
- la figure 7, une illustration de la bande passante d'un filtre utilisé dans l'exemple de réalisation de la figure 6 ;
- la figure 8, une illustration de la réponse impulsionnelle du filtre précité ;
- la figure 9, un autre exemple de réalisation d'un dispositif selon l'invention.

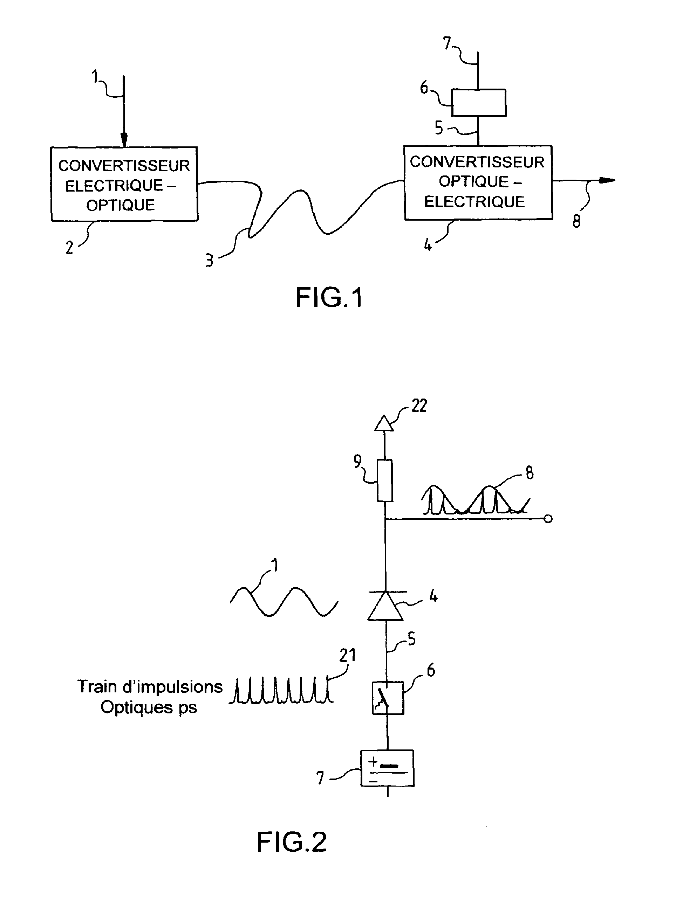

La figure 1 illustre un exemple de réalisation d'un dispositif selon l'invention, à base d'un convertisseur électrique-optique et d'un convertisseur optique-électrique commandé en tension impulsionnelle. Ce dispositif utilise notamment une liaison optique hyperfréquence dont la photodiode est commandée électriquement par des impulsions de tension ultra courtes, réalisant ainsi l'échantillonnage du signal lors de la démodulation du domaine optique vers le domaine électrique. La figure 1 présente un exemple de mise en oeuvre.
Ainsi, un signal hyperfréquence 1 est placé sur une porteuse optique via un convertisseur électrique-optique 2. Ce signal hyperfréquence 1 d'entrée est le signal à échantillonner en vue par exemple de sa conversion analogique-numérique.
Le convertisseur électrique-optique 2 peut par exemple être réalisé soit par un laser à modulation directe, soit par un laser continu couplé à un modulateur électro-optique, soit encore un laser impulsionnel couplé à un modulateur électro-optique. Une fibre optique 3 assure le transport du signal optique en sortie du convertisseur 2 jusqu'à un convertisseur optique électrique 4. Ce dernier est par exemple une photodiode. Le convertisseur optique-électrique fournit en sortie un signal électrique proportionnel au signal de modulation de la porteuse optique véhiculée par la fibre optique, c'est-à-dire un signal proportionnel au signal hyperfréquence à convertir.
La tension 5 polarisant la photodiode 4 est générée par un dispositif 6 alimenté par une tension d'alimentation 7. Si le dispositif 6 génère une tension de polarisation 5 continue, alors le signal 8 en sortie du convertisseur optique électrique 4 est le signal hyperfréquence d'entrée 1, aux pertes de la transmission près. Si la tension de polarisation 5 générée par le dispositif 6 se présente sous la forme d'impulsions électriques, alors le signal 8 en sortie du convertisseur optique électrique 4 est nul lorsque la tension de polarisation est nulle, et correspond au signal d'entrée 1 moins les pertes de transmission lorsque la tension de polarisation atteint sa valeur nominale. Plusieurs solutions sont envisageables pour réaliser le dispositif de génération de tension de polarisation 6, en particulier la commande de la tension de polarisation peut être par exemple :
- une commande par un composant électronique :

- ou une commande par un composant optoélectronique commandé, optiquement, par exemple, par un commutateur photoconducteur dont la résistance dépend de la puissance optique qui est injectée dans sa zone active.
Dans le cas de la commande par un composant électronique, ce dernier peut être par exemple :
- un transistor à effet de champ de type FET monté en commutateur et qui est par défaut non passant lorsqu'une impulsion est présente sur sa grille ;
- ou un générateur de peigne basé sur une diode varactor.
Plus généralement pour le dispositif 6 on peut utiliser tout dispositif capable de faire commuter une photodiode, dans le cas où le convertisseur optique électrique est composé d'une photodiode. Par la suite on considère que le convertisseur optique électrique est une photodiode.
Un intérêt d'un dispositif selon l'invention est, notamment, qu'il joue sur la tension de polarisation 5 de la photodiode 4 et qu'une variation typiquement d'une dizaine de dB de la tension de polarisation de la photodiode permet de faire varier le signal photo-détecté par cette photodiode de plus de 40 dB. En d'autres termes, lorsque la photodiode est polarisée elle détecte parfaitement bien les signaux qui se présentent à son entrée. En particulier, elle détecte parfaitement bien le signal hyperfréquence d'entrée transportée par la porteuse optique. Un autre intérêt dans le fonctionnement d'un dispositif selon l'invention est, notamment, qu'au-delà de la tension de polarisation typique d'une photodiode, et dans la mesure où la tension de polarisation de la photodiode reste inférieure à sa valeur maximale, le gain du signal n'évolue plus. Ainsi, cela permet de relâcher considérablement les contraintes sur le niveau de bruit d'amplitude du système commandant la tension de polarisation de la photodiode.

La figure 2 présente un exemple de réalisation dans le cas où la commande de la tension de polarisation 5 est réalisée par un commutateur photoconducteur 6. Ce dernier est, par exemple, réalisé sur un matériau standard classique AsGa ou InP ou ce même type de matériau sur lequel un dépôt AsGa a été réalisé à basse température par exemple, ou tout autre matériau photoconducteur. Le commutateur photoconducteur 6 est activé optiquement par une source laser impulsionnelle. De cette source laser impulsionnelle il reçoit des trains d'impulsions optiques 21, chaque impulsion ayant, par exemple, une largeur moyenne de l'ordre de quelque picosecondes. Le commutateur photoconducteur 6 activé par les impulsions optiques génère, à partir de l'alimentation 7, une tension permettant de polariser la photodiode 4 chargée ou non sur une résistance de charge 9, reliée elle-même à un potentiel de référence 22, par exemple, une masse électrique. Selon la valeur de la tension de polarisation, la photodiode 4 détecte ou ne détecte pas le signal hyperfréquence 1 présent à son entrée et porté optiquement, par exemple, par la fibre optique 3. En fait le signal présent à l'entrée est la porteuse optique modulée par le signal hyperfréquence 1. Dans la suite, on assimilera ce signal hyperfréquence à la modulation de la porteuse optique.
Le signal 8 en sortie de cette photodiode 4 est, dans ce cas, une série d'impulsions dont l'amplitude dépend de la valeur du signal hyperfréquence. Ces impulsions du signal de sortie 8 ont sensiblement la même largeur que les impulsions optiques qui activent le dispositif de génération de tension de polarisation 6, elles sont modulées par le signal hyperfréquence 1. On retrouve ainsi en sortie 8 le signal d'entrée 1 échantillonné à la fréquence du signal optique 21 qui commande la tension de polarisation de la photodiode 4, avec des largeurs d'impulsion d'échantillonnage ultra courtes.
La photodiode 4 étant un élément imparfait, lorsqu'elle n'est pas polarisée, elle laisse passer une petite partie de signal dont le niveau est néanmoins très faible. II est en effet au moins 40 dB plus faible que lorsque la photodiode est polarisée.

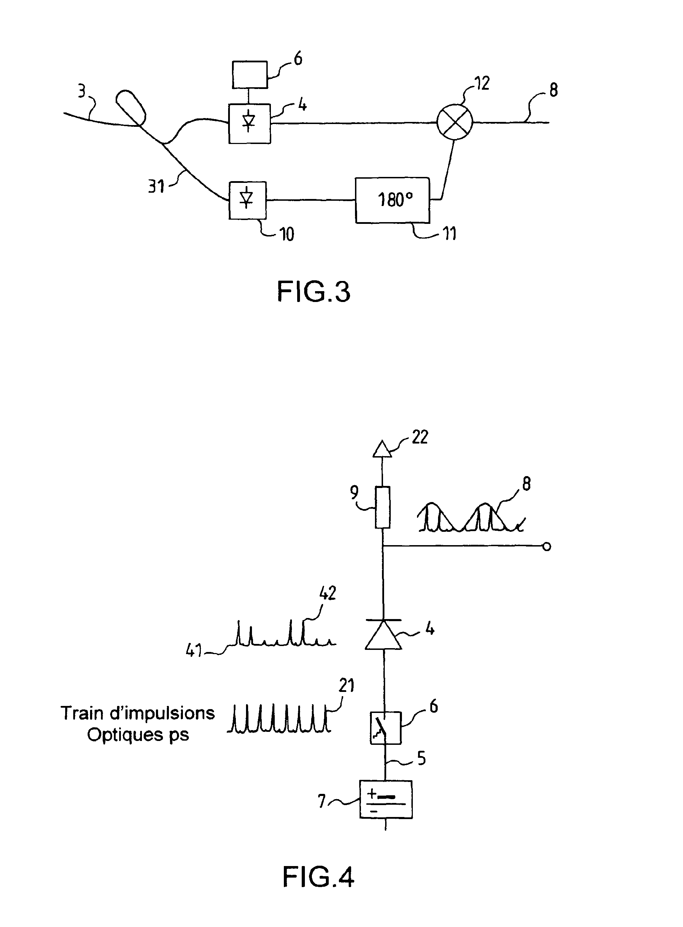

La figure 3 montre, par un autre exemple de réalisation, qu'il est possible par une technique identique au neutrodynage de diminuer encore le niveau minimal en sortie de la photodiode 4 lorsqu'elle n'est pas polarisée. Dans le mode de réalisation de la figure 3, une deuxième photodiode 10 est utilisée. Cette deuxième photodiode n'est pas polarisée. Cette deuxième photodiode 10 est aussi illuminée par la porteuse optique du signal hyperfréquence. A cet effet, une autre branche 31 de la fibre optique 3 est, par exemple, reliée à cette deuxième photodiode 10. Ainsi, dans l'exemple de réalisation de la figure 3, la fibre optique 3 sur laquelle se trouve porté optiquement le signal 1 à convertir illumine optiquement les deux photodiodes 4, 10. La première photodiode 4 a sa tension de polarisation commandée par le dispositif 6 de génération de polarisation, tandis que la deuxième photodiode 10 n'a pas sa tension de polarisation commandée. Le signal en sortie de la première photodiode 4 dépend de sa tension de polarisation et est donc, soit représentative du signal hyperfréquence à convertir, soit très faible. En sortie de la deuxième photodiode 10, le signal est très faible et identique au signal de sortie de la première photodiode 4 lorsqu'elle n'est pas polarisée. Un sommateur 12 réalise la somme du signal issu de la première photodiode 4 et du signal issu de la deuxième photodiode 10 déphasé de 180° par un déphaseur 11. Dans ce mode de réalisation, la sortie du sommateur délivre le signal de sortie 8 du dispositif selon l'invention.
Lorsque la tension de polarisation de la première photodiode est nulle, le signal en sortie du sommateur 12 est nul. En effet, les faibles valeurs résiduelles des sorties des deux photodiodes présentes à l'entrée du déphaseur s'annulent. La valeur résiduelle présente en sortie du premier déphaseur 4 disparaît donc ainsi. Lorsque la tension de polarisation de la photodiode 4 n'est pas nulle, le signal de sortie 8 est représentatif du signal à convertir. La faible valeur résiduelle de la deuxième photodiode qui est retranchée à ce signal de sortie 8 est alors négligeable.

La figure 4 présente un exemple de réalisation, appliqué au mode de réalisation de la figure 2, où le convertisseur électrique optique 2 est réalisé à l'aide d'une source laser impulsionnelle et d'un modulateur électro-optique. Il y a en fait un premier échantillonnage, dans le domaine optique, au niveau du convertisseur 2 au moyen de la source impulsionnelle. Le signal 41 présent à l'entrée de la photodiode n'est plus le signal hyperfréquence 1 comme dans le cas de la figure 2, mais une succession d'impulsions 42 dont l'amplitude est modulée par le signal hyperfréquence 1 que l'on cherche à convertir. Les impulsions 21 qui activent le dispositif 6 de génération de la tension de polarisation doivent être synchronisées avec les impulsions 42 présentes à l'entrée de la photodiode 4. Cela peut se faire naturellement, dans la mesure ou ces impulsions 42 proviennent de la source impulsionnelle du convertisseur électrique optique 2 qui réalise le premier échantillonnage du signal hyperfréquence dans le domaine optique. Un mode de réalisation superpose deux échantillonnages permettant de réduire encore les largeurs des impulsions du signal électrique échantillonné 8 en sortie du dispositif. En fait, en jouant sur la superposition des deux séries d'échantillons il est possible d'affiner la largeur des impulsions du signal échantillonné en sortie.

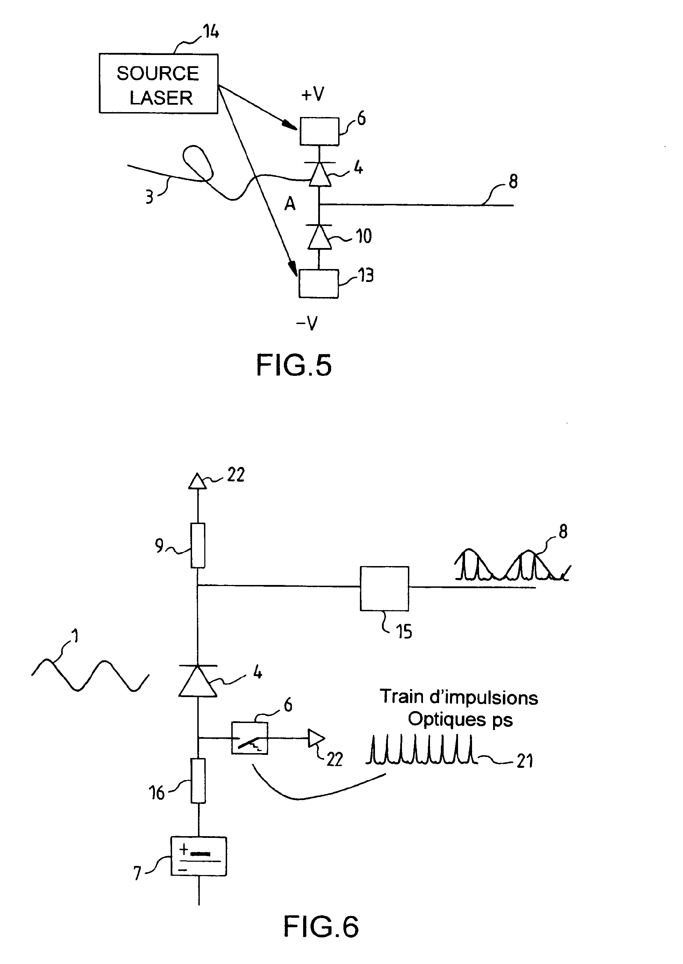

La figure 5 présente un autre exemple de réalisation basé sur l'emploi d'une double commande et de deux photodiodes 4, 10 dites équilibrées, l'anode de la première photodiode 4 étant reliée à la cathode de la deuxième photodiode 10. Cet exemple de réalisation permet de diminuer les effets de la commande impulsionnelle de la tension de polarisation des photodiodes. Le dispositif de la figure 5 est basé sur la commande simultanée, par une source laser 14, des deux photodiodes 4, 10 polarisées par des tensions inverses +V et -V au moyen de deux dispositifs 6, 13 de générations de tensions de polarisation. Dans ce système seule une première photodiode 4 est illuminée par la porteuse optique du signal hyperfréquence 1 à convertir. A cet effet, seule cette première photodiode 4 est illuminée par la fibre optique 3 transportant le signal 1 à convertir. La sortie 8 est reliée au point milieu A des deux photodiodes 4, 10, situé entre l'anode de la première photodiode 4 et la cathode de la deuxième photodiode 10.
Ainsi, sur la sortie 8 le signal présent est proportionnel au signal à convertir mais les effets dus à la commande impulsionnelle de la tension de polarisation sont éliminés car ils se soustraient en ce point A du fait de la commande simultanée des deux photodiodes 4, 10 polarisées par deux tensions opposées. En l'absence de polarisation, la sortie 8 présente un zéro sensiblement parfait. Ce mode de réalisation présenté par la figure 5 est un autre exemple permettant, comme le mode de réalisation de la figure 3, d'obtenir un zéro sensiblement parfait en sortie.

La figure 6 présente un autre exemple de réalisation d'un dispositif selon l'invention. Dans ce mode de réalisation, la tension de polarisation est toujours présente. Elle est fournie à la photodiode 4 par la tension d'alimentation 7 via une résistance 16. Le dispositif 6 de commande de la tension de polarisation de la photodiode 4 n'est utilisé que pour faire disparaître cette tension à l'entrée de la photodiode 4. En position commandée, il dérive la sortie de la résistance 16 au potentiel de référence 22, par exemple la masse électrique. A cet effet, il est connecté entre ce potentiel de référence 22 et le point de connexion de la résistance 19 avec la photodiode 4. Ce dispositif de commande est par exemple un commutateur à commande optique.
Ainsi, en sortie de la photodiode 4 le signal est toujours présent, sauf lorsque le commutateur à commande optique 6 reçoit une impulsion optique fournie par le train d'impulsions 21. La sortie de la photodiode 4 est aussi reliée à la résistance de charge 9. La photodiode est, par ailleurs, illuminée par la porteuse du signal d'entrée 1.
Afin de ne pas toujours avoir du signal en sortie du dispositif, un filtre passe-bas 15 est aussi placé en sortie de la photodiode 4. La sortie du filtre 15 est la sortie 8 du dispositif.
La fonction du filtre passe-bas est au moins double :
- Filtrer le signal d'entrée 1 afin qu'il ne soit jamais présent en sortie de la photodiode 4, l'atténuation de ce filtre à la fréquence minimale du signal 1 à convertir doit être supérieure ou égale à la résolution souhaitée. Cette atténuation peut être par exemple égale à 6,02 x n + 1,78 dB, où n est le nombre de bits du système d'échantillonnage placé derrière ;
- Posséder une réponse impulsionnelle telle que, sur le haut de son impulsion, le temps pour lequel le signal reste constant à mieux qu'un demi LSB (bit de poids le plus faible) soit supérieur ou égal au temps nécessaire pour réaliser la conversion.

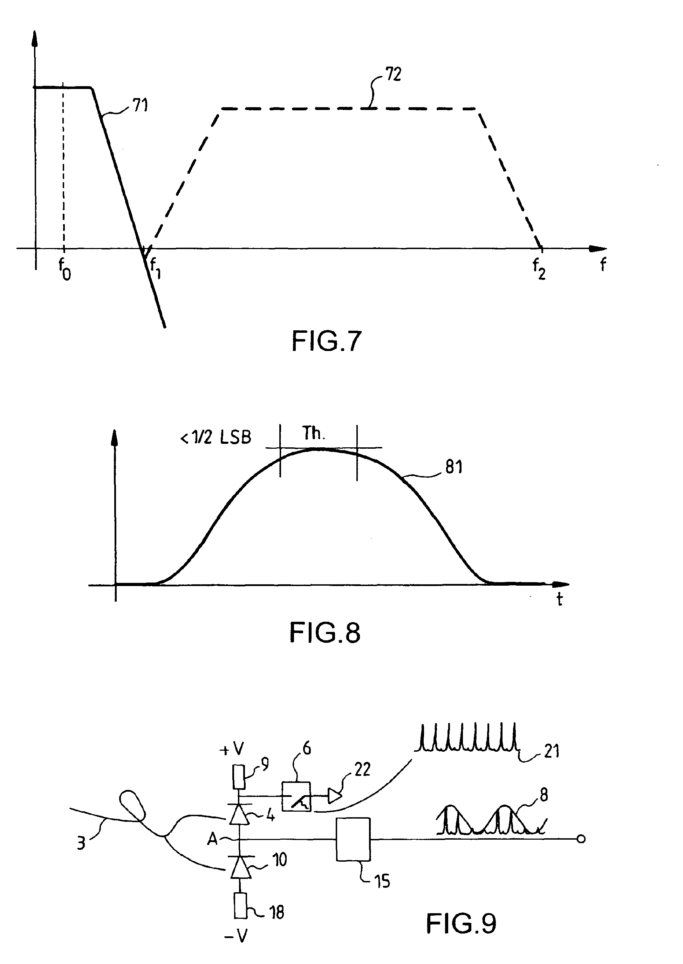

La figure 7 illustre un exemple de la bande passante du filtre 15. Plus précisément, elle illustre par une courbe 71 la fonction de transfert de ce filtre passe-bas. Ce dernier laisse notamment passer la fréquence d'échantillonnage f₀ qui est comprise dans sa bande passante. II filtre notamment la bande de fréquences 72 comprise entre deux fréquences f₁ et f₂, cette bande comportant la fréquence des signaux 1 à échantillonner présents à l'entrée du dispositif.

La figure 8 illustre la réponse impulsionnelle du filtre passe-bas 15. Cette réponse est illustrée par une courbe 81 représentant une impulsion en fonction du temps t. Sur le haut de l'impulsion 81, le temps Th correspond au temps pour lequel le signal reste constant au mieux que ½ LSB. Ce temps est supérieur ou égal au temps nécessaire pour réaliser une conversion analogique-numérique.
Un mode de réalisation du type de la figure 6 s'applique, par exemple, pour convertir un signal de fréquence comprise entre les fréquences f₁ et f₂ au moyen d'un dispositif réalisé par l'entrelacement de plusieurs convertisseurs analogique-numérique fonctionnant à une fréquence d'échantillonnage f₀, f₀ étant inférieure à f₁.

La figure 9 présente un autre exemple de réalisation. Comme précédemment, il est possible d'utiliser un dispositif à base de photodiodes équilibrées afin d'augmenter le contraste et de s'affranchir des effets de la commande de la tension de polarisation par impulsions. Dans le mode de réalisation qui utilise deux photodiodes 4, 10, les deux photodiodes 4, 10 sont éclairées par la fibre optique 3 véhiculant le signal 1 à échantillonner, comme dans l'exemple de réalisation de la figure 3. Mais dans ce cas, la polarisation des deux photodiodes est toujours présentes via deux résistances 9, 18, mais seule la première photodiode 4 est commandée de façon impulsionnelle. Une résistance 9 relie la cathode de la première photodiode 4 au potentiel +V. Une résistance 18 relie l'anode de la deuxième photodiode 10 au potentiel -V. Le filtre passe-bas 15 est relié au point milieu A des deux photodiodes 4, 10. Le filtre passe-bas a les mêmes caractéristiques que le précédent, illustrées notamment par les figures 7 et 8. Un dispositif 6 de commande de polarisation de la première photodiode relie sa cathode au potentiel de référence 22. Ce dispositif de commande 6 est toujours activé par le train d'impulsions optiques 21.
La polarisation des deux photodiodes est donc toujours présente, si bien que, le signal 8 en sortie du filtre 15 est toujours nul. Lorsque le dispositif 6 de commande de polarisation de la première photodiode 4 annule la polarisation de la première photodiode 4, une impulsion est présente en sortie du filtre passe-bas 15. Le signal 8 en sortie du filtre 15 comporte des impulsions dont l'amplitude dépend de la valeur du signal à convertir.

## Revendications

1. Dispositif d'échantillonnage d'un signal, comportant au moins :
- un convertisseur électrique-optique (2) fournissant une porteuse optique modulée par le signal (1) ;
- un convertisseur optique-électrique (4) illuminé par la porteuse optique et commandé par des impulsions de tension (5), le convertisseur optique-électrique (4) fournissant en sortie (8) un signal proportionnel au signal de modulation de la porteuse optique lorsqu'il est commandé en tension, le signal de sortie (8) étant le signal échantillonné ;
**caractérisé en ce que** le convertisseur optique-électrique est une photodiode (4) dont la polarisation est commandée par les impulsions de tension (5).

2. Dispositif selon la revendication 1, **caractérisé en ce que** le convertisseur optique-électrique (4) fournit en sortie un signal (8) proportionnel au signal de modulation de la porteuse optique lorsque la tension (5) est non nulle.

3. Dispositif selon l'une quelconque des revendications précédentes, **caractérisé en ce que** les impulsions de tension (5) sont générées à partir d'une tension d'alimentation (7) commutée, la tension (7) étant commutée par un commutateur photoconducteur (6), le commutateur photoconducteur (6) étant activé par des impulsions optiques (21).

4. Dispositif selon l'une quelconque des revendications précédentes, **caractérisé en ce qu'**il comporte une deuxième photodiode (10) illuminée par la porteuse optique, la deuxième photodiode (10) n'étant pas polarisée et son signal de sortie étant soustrait au signal de sortie de la première photodiode (4) pour former le signal de sortie échantillonné (8).

5. Dispositif selon la revendication 4, **caractérisé en ce que** la sortie du deuxième photodétecteur (10) est reliée à un déphaseur de 180° (11), la sortie du premier photodétecteur (4) et la sortie du déphaseur (11) étant reliées aux entrées d'un sommateur (12) dont la sortie fournit le signal de sortie échantillonné (8).

6. Dispositif selon l'une quelconque des revendications précédentes, **caractérisé en ce qu'**il comporte une deuxième photodiode (10) qui n'est pas illuminée par la porteuse optique, la cathode de la deuxième photodiode (10) étant reliée à l'anode de la première photodiode (4), les deux photodiodes étant commandées en tension simultanément, le signal de sortie échantillonné (8) étant situé au point milieu (A) des deux photodiodes.

7. Dispositif selon l'une quelconque des revendications précédentes, **caractérisé en ce que** la tension de polarisation est appliquée sur la photodiode (4) via une résistance (16), la tension de polarisation étant annulée par un commutateur à commande impulsionnelle (6), un filtre passe-bas (15) filtrant le signal en sortie de la photodiode (4), la sortie du filtre fournissant le signal de sortie échantillonné (8).

8. Dispositif selon la revendication 7, **caractérisé en ce que** le commutateur à commande impulsionnelle est un commutateur à commande optique (6) portant la résistance à un potentiel de référence (22) lorsqu'il reçoit une impulsion optique (21).

9. Dispositif selon la revendication 8, **caractérisé en ce que** l'anode de la photodiode (4) est reliée à la résistance (16) et au commutateur à commande optique (6), la résistance (16) étant par ailleurs reliée à une tension d'alimentation (7), le commutateur (6) étant activé par des impulsions optiques (21).

10. Dispositif selon l'une quelconque des revendications précédentes, **caractérisé en ce qu'**il comporte une deuxième photodiode (10) illuminée par la porteuse optique, la cathode de la deuxième photodiode étant reliée à l'anode de la première photodiode (4), les deux photodiodes étant commandées en tension simultanément, la première photodiode (4) ayant sa tension de polarisation commandée de façon impulsionnelle, un filtre passe-bas (15) étant connecté au point milieu (A) des deux photodiodes, la sortie du filtre passe-bas (15) délivrant le signal de sortie échantillonné.

11. Dispositif selon la revendication 10, **caractérisé en ce que** la première photodiode (4) est reliée à une tension d'alimentation +V par une résistance (9), la deuxième photodiode (10) est reliée à une tension d'alimentation -V par une résistance (18), la cathode de la première photodiode (4) étant annulée par un commutateur à commande impulsionnelle (6).

12. Dispositif selon l'une quelconque des revendications précédentes, **caractérisé en ce que** la porteuse optique est échantillonnée dans le domaine optique.

13. Dispositif selon la revendication 12, **caractérisé en ce que** le convertisseur électro-optique (2) comporte une source laser impulsionnelle couplée à un modulateur électro-optique.

14. Dispositif selon l'une quelconque des revendications précédentes, **caractérisé en ce que** la porteuse optique est véhiculée par une fibre optique (3, 31).

## Claims

1. Signal sampling device comprising at least:
- an electrical-optical converter (2) providing an optical carrier wave modulated by the signal (1);
- an optical-electrical converter (4) illuminated by the optical carrier wave and controlled by voltage pulses (5), the optical-electrical converter (4) providing at its output (8) a signal proportional to the modulation signal of the optical carrier wave when it is voltage-controlled, the output signal (8) being the sampled signal;
**characterized in that** the optical-electrical converter is a photodiode (4), the bias of which is controlled by the voltage pulses (5).

2. Device according to Claim 1, **characterized in that** the optical-electrical converter (4) provides at its output a signal (8) proportional to the modulation signal of the optical carrier wave when the voltage (5) is non-zero.

3. Device according to either of the preceding claims, **characterized in that** the voltage pulses (5) are generated from a switched supply voltage (7), the voltage (7) being switched by a photoconductive switch (6), the photoconductive switch (6) being activated by optical pulses (21).

4. Device according to any one of the preceding claims, **characterized in that** it comprises a second photodiode (10) illuminated by the optical carrier wave, the second photodiode (10) not being biased and its output signal being subtracted from the output signal of the first photodiode (4) to form the sampled output signal (8).

5. Device according to Claim 4, **characterized in that** the output of the second photodetector (10) is connected to a 180° phase shifter (11), the output of the first photodetector (4) and the output of the phase shifter (11) being connected to the inputs of a summer (12) the output of which provides the sampled output signal (8).

6. Device according to any one of the preceding claims, **characterized in that** it comprises a second photodiode (10) which is not illuminated by the optical carrier wave, the cathode of the second photodiode (10) being connected to the anode of the first photodiode (4), the two photodiodes being simultaneously voltage-controlled, the sampled output signal (8) being situated at the midpoint (A) of the two photodiodes.

7. Device according to any one of the preceding claims, **characterized in that** the bias voltage is applied to the photodiode (4) via a resistor (16), the bias voltage being cancelled by a pulse-controlled switch (6), a low-pass filter (15) filtering the output signal of the photodiode (4), the output of the filter providing the sampled output signal (8).

8. Device according to Claim 7, **characterized in that** the pulse-controlled switch is an optically controlled switch (6) raising the resistor to a reference potential (22) when it receives an optical pulse (21).

9. Device according to Claim 8, **characterized in that** the anode of the photodiode (4) is connected to the resistor (16) and to the optically controlled switch (6), the resistor (16) being moreover connected to a supply voltage (7), the switch (6) being activated by optical pulses (21).

10. Device according to any one of the preceding claims, **characterized in that** it comprises a second photodiode (10) illuminated by the optical carrier wave, the cathode of the second photodiode being connected to the anode of the first photodiode (4), the two photodiodes being simultaneously voltage-controlled, the first photodiode (4) having its bias voltage controlled by pulses, a low-pass filter (15) being connected to the midpoint (A) of the two photodiodes, the output of the low-pass filter (15) delivering the sampled output signal.

11. Device according to Claim 10, **characterized in that** the first photodiode (4) is connected to a supply voltage +V via a resistor (9), the second photodiode (10) is connected to a supply voltage -V via a resistor (18), the cathode of the first photodiode (4) being cancelled by a pulse-controlled switch (6).

12. Device according to any one of the preceding claims, **characterized in that** the optical carrier wave is sampled in the optical domain.

13. Device according to Claim 12, **characterized in that** the electro-optical converter (2) comprises a pulsed laser source coupled to an electro-optical modulator.

14. Device according to any one of the preceding claims, **characterized in that** the optical carrier wave is carried by an optical fibre (3, 31).

## Patentansprüche

1. Vorrichtung zur Abtastung eines Signals, die mindestens aufweist:
- einen elektrisch-optischen Wandler (2), der eine vom Signal (1) modulierte optische Trägerwelle liefert;
- einen optisch-elektrischen Wandler (4), der von der optischen Trägerwelle beleuchtet und von Spannungsimpulsen (5) gesteuert wird, wobei der optisch-elektrische Wandler (4) am Ausgang ein Signal (8) proportional zum Modulationssignal der optischen Trägerwelle liefert, wenn er spannungsgesteuert wird, wobei das Ausgangssignal (8) das abgetastete Signal ist;
**dadurch gekennzeichnet, dass** der optisch-elektrische Wandler eine Photodiode (4) ist, deren Polarisation von den Spannungsimpulsen (5) gesteuert wird.

2. Vorrichtung nach Anspruch 1, **dadurch gekennzeichnet, dass** der optisch-elektrische Wandler (4) am Ausgang ein Signal (8) proportional zum Modulationssignal der optischen Trägerwelle liefert, wenn die Spannung (5) ungleich Null ist.

3. Vorrichtung nach einem der vorhergehenden Ansprüche, **dadurch gekennzeichnet, dass** die Spannungsimpulse (5) ausgehend von einer geschalteten Speisespannung (7) erzeugt werden, wobei die Spannung (7) von einem photoleitenden Schalter (6) geschaltet wird, wobei der photoleitende Schalter (6) von optischen Impulsen (21) aktiviert wird.

4. Vorrichtung nach einem der vorhergehenden Ansprüche, **dadurch gekennzeichnet, dass** sie eine zweite Photodiode (10) aufweist, die von der optischen Trägerwelle beleuchtet wird, wobei die zweite Photodiode (10) nicht polarisiert ist und ihr Ausgangssignal vom Ausgangssignal der ersten Photodiode (4) subtrahiert wird, um das abgetastete Ausgangssignal (8) zu bilden.

5. Vorrichtung nach Anspruch 4, **dadurch gekennzeichnet, dass** der Ausgang des zweiten Photodetektors (10) mit einem 180°-Phasenschieber (11) verbunden ist, wobei der Ausgang des ersten Photodetektors (4) und der Ausgang des Phasenschiebers (11) mit den Eingängen eines Summierglieds (12) verbunden sind, dessen Ausgang das abgetastete Ausgangssignal (8) liefert.

6. Vorrichtung nach einem der vorhergehenden Ansprüche, **dadurch gekennzeichnet, dass** sie eine zweite Photodiode (10) aufweist, die nicht von der optischen Trägerwelle beleuchtet wird, wobei die Kathode der zweiten Photodiode (10) mit der Anode der ersten Photodiode (4) verbunden ist, wobei die zwei Photodioden gleichzeitig spannungsgesteuert werden, wobei das abgetastete Ausgangssignal (8) sich im Mittelpunkt (A) der zwei Photodioden befindet.

7. Vorrichtung nach einem der vorhergehenden Ansprüche, **dadurch gekennzeichnet, dass** die Polarisationsspannung an die Photodiode (4) über einen Widerstand (16) angelegt wird, wobei die Polarisationsspannung von einem impulsgesteuerten Schalter (6) auf Null gesetzt wird, wobei ein Tiefpassfilter (15) das Signal am Ausgang der Photodiode (4) filtert, wobei der Ausgang des Filters das abgetastete Ausgangssignal (8) liefert.

8. Vorrichtung nach Anspruch 7, **dadurch gekennzeichnet, dass** der impulsgesteuerte Schalter ein optisch gesteuerter Schalter (6) ist, der den Widerstand auf ein Bezugspotential (22) bringt, wenn er einen optischen Impuls (21) empfängt.

9. Vorrichtung nach Anspruch 8, **dadurch gekennzeichnet, dass** die Anode der Photodiode (4) mit dem Widerstand (16) und mit dem optisch gesteuerten Schalter (6) verbunden ist, wobei der Widerstand (16) außerdem mit einer Speisespannung (7) verbunden ist, wobei der Schalter (6) von optischen Impulsen (21) aktiviert wird.

10. Vorrichtung nach einem der vorhergehenden Ansprüche, **dadurch gekennzeichnet, dass** sie eine zweite Photodiode (10) aufweist, die von der optischen Trägerwelle beleuchtet wird, wobei die Kathode der zweiten Photodiode mit der Anode der ersten Photodiode (4) verbunden ist, wobei die zwei Photodioden gleichzeitig spannungsgesteuert werden, wobei die Polarisationsspannung der ersten Photodiode (4) impulsgesteuert wird, wobei ein Tiefpassfilter (15) mit dem Mittelpunkt (A) der zwei Photodioden verbunden ist, wobei der Ausgang des Tiefpassfilters (15) das abgetastete Ausgangssignal liefert.

11. Vorrichtung nach Anspruch 10, **dadurch gekennzeichnet, dass** die erste Photodiode (4) mit einer Speisespannung +V über einen Widerstand (9) verbunden ist, die zweite Photodiode (10) mit einer Speisespannung -V über einen Widerstand (18) verbunden ist, wobei die Kathode der ersten Photodiode (4) von einem impulsgesteuerten Schalter (6) auf Null gesetzt wird.

12. Vorrichtung nach einem der vorhergehenden Ansprüche, **dadurch gekennzeichnet, dass** die optische Trägerwelle im optischen Bereich abgetastet wird.

13. Vorrichtung nach Anspruch 12, **dadurch gekennzeichnet, dass** der elektro-optische Wandler (2) eine Impulslaserquelle aufweist, die mit einem elektro-optischen Modulator gekoppelt ist.

14. Vorrichtung nach einem der vorhergehenden Ansprüche, **dadurch gekennzeichnet, dass** die optische Trägerwelle von einer Lichtleitfaser (3, 31) transportiert wird.
